Europäisches Patentamt

European Patent Office

Office européen des brevets

(19)

(11) Veröffentlichungsnummer: **0 085 868**
**B1**

(12) **EUROPÄISCHE PATENTSCHRIFT**

(45) Veröffentlichungstag der Patentschrift:
08.01.86

(51) Int. Cl.⁴: **G 01 R 31/28, G 01 B 11/06**

(21) Anmeldenummer: **83100524.4**

(22) Anmeldetag: **21.01.83**

(54) Vorrichtung zur automatischen optischen Beschaffenheitsprüfung.

(30) Priorität: **06.02.82 DE 3204086**

(43) Veröffentlichungstag der Anmeldung:
**17.08.83 Patentblatt 83/33**

(45) Bekanntmachung des Hinweises auf die Patenterteilung:
**08.01.86 Patentblatt 86/2**

(84) Benannte Vertragsstaaten:
**DE FR GB**

(56) Entgegenhaltungen:
**EP - A - 0 023 574**
**DE - B - 2 012 446**
**DE - B - 2 355 185**
**US - A - 4 053 234**

**MICROTECNIC, Nr. 2, 1980, Zürich, B. FRICKER "Das Optocator-System für vielseitigen Einsatz bei berührungslosen Präzisionsmessungen", Seiten 5-7**

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB**

(72) Erfinder: **Grammerstorff, Michael Ing. grad., Kniebisstrasse 14, D-7031 Aidlingen (DE)**
Erfinder: **Pietruschka, Hans, Sontheimer Strasse 8, D-7407 Rottenburg 2 (DE)**

(74) Vertreter: **Teufel, Fritz, Dipl.-Phys. et al, IBM Deutschland GmbH. Europäische Patentdienste Postfach 265, D-8000 München 22 (DE)**

ACTORUM AG

## Beschreibung

Die Erfindung betrifft eine Vorrichtung zur automatischen optischen Beschaffenheitsprüfung nach dem Oberbegriff des Hauptanspruchs.

Die visuelle Prüfung von Gegenständen auf Fehler und Einhaltung von Konstruktionsvorgaben stellt häufig eine langwierige, ermüdende und fehlerbehaftete Aufgabe dar; dies trifft insbesondere bei der Fertigung von komplexen, im wesentlichen zweidimensionalen Mustern zu, wie sie in Leiterbahnen oder Lithographiemasken vorkommen. Die Vielzahl der zu überprüfenden Strukturelemente in diesen Mustern und die erforderliche Prüfung jedes hergestellten Stücks erschwert die Aussonderung von defekten Teilen ganz beträchtlich und kann bedeutende Folgekosten verursachen, wenn fehlerhafte Zwischenprodukte verwendet werden, deren Fehler sich erst nach vielen weiteren Herstellschritten auswirkt.

Besonders wichtig ist die optische Beschaffenheitsprüfung bei Leiterplatten, die aus mehreren Einzellagen mit individuellen Leitungsmustern zusammengesetzt werden (sogenannte Multi Layer Cards); die dort vielfach angewandte elektrische Durchgangsprüfung für die einzelnen Leiterzüge zeigt selbst dann ein fehlerfreies Bauteil an, wenn einzelne Abmessungen, beispielsweise der minimale Abstand zwischen zwei Leitungsbahnen, nicht überall eingehalten sind. Derartige Fehler machen sich in vielen Fällen erst nach längerem Einsatz der Platte bemerkbar, wenn an diesen fehlerhaften Stellen z.B. durch elektrischen Materialtransport ein Kurzschluss oder z.B. durch mechanische Beanspruchung eine Unterbrechung entsteht.

Zur Untersuchung von Leiterplatten und ähnlichen im wesentlichen zweidimensionalen Mustern sind im Stand der Technik zwei grundsätzlich verschiedene Wege bekannt: Der erste besteht darin, ein hergestelltes Bauteil mit einem fehlerhaften Muster punktweise zu vergleichen, um somit alle Abweichungen festzustellen. Ein derartiges System ist beispielsweise in dem Artikel von E. Krochmann und P. Wirz «Automatischer Vektordistanzkomparator VDK Projectina» in Feinwerktechnik & Messtechnik 84 (1976), Heft 7, Seiten 330-334 beschrieben. Dieses Verfahren hat jedoch den Nachteil, dass Probe und Muster sehr genau gegeneinander ausgerichtet werden müssen, und dass selbst dann noch viele Abweichungen als Fehler angezeigt werden, die die Funktionstüchtigkeit des geprüften Bauteils nicht beeinträchtigen (z.B. an sich unschädliche kleine Relativverschiebungen von einzelnen Teilbereichen innerhalb des Musters). Ausserdem ist ein relativ hoher Zeitaufwand für diese Prüfung erforderlich. Statt des direkten optischen Vergleichs kann der Prüfling auch mit einem Bildwandler abgetastet und das entstehende digitalisierte Bild mit einer gespeicherten Digital-Darstellung des Musters verglichen werden.

Ein weiteres Prüfverfahren besteht darin, nur jeweils relativ kleine Ausschnitte aus der zu untersuchenden Oberfläche daraufhin zu untersuchen, ob dort die Konstruktionsvorschriften für das betreffende Muster eingehalten sind. Eine derartige Prüfung erstreckt sich beispielsweise auf die minimalen und maximalen Leiterquerschnitte, die gegenseitigen Leiterabstände und das Auftreten von erlaubten grösseren Leitergebieten, beispielsweise Lötaugen. Dieses Prüfverfahren eignet sich besonders für die regelmässig strukturierten Muster in Leiterplatten u.ä., da sich dafür relativ einfache Abgrenzungskriterien ergeben und der Schaltungsaufwand zur Durchführung des Verfahrens gering bleibt. Bei digitaler Bildverarbeitung fällt hier insbesondere der Speicher von hoher Kapazität für die Speicherung der Musterdaten weg. Ein Beispiel für ein derartiges opto-elektronisches Prüfsystem zur automatischen Beschaffenheitsprüfung von Leiterplatten ist in der Europäischen Patentanmeldung 23 574 zu finden.

Die im Stand der Technik beschriebenen Verfahren und Vorrichtungen zur optischen Beschaffenheitsprüfung beschränken sich auf das zweidimensionale Bild des zu untersuchenden Gegenstands, beispielsweise einer Leiterplatte, das beim Abtasten der Vorlage, beispielsweise mit einer Fernsehkamera, entsteht. Die Leiterzüge auf einer Leiterplatte sind jedoch in Wirklichkeit dreidimensionale Gebilde, deren Dicke ebenfalls ein wesentlicher Konstruktionsparameter darstellt, der innerhalb gewisser Grenzen liegen muss; wird die Nominaldicke unterschritten, so kann beim Durchgang eines Stromes nach einiger Zeit infolge Materialtransport eine Unterbrechung der Leiterbahn auftreten; bei einer Überschreitung der Dicke können sich Probleme beim Laminieren von Zwischenschichten in die endgültige Leiterplatte ergeben.

Im Stand der Technik sind zur Überwachung der Höhenlage oder der Dicken von Produkten sogenannte Lichtschnitt-Verfahren bekannt. Ein Beispiel dafür liefert die US-A-4 053 234, bei der das zu überwachende Produkt, nämlich Backwaren, schräg mit einem Lichtfleck beleuchtet wird; dieser Lichtfleck wird auf eine Photodiodenanordnung abgebildet, die in der optischen Einfallsebene senkrecht über dem Gebäckstück liegt. Die Lage dieses Bildes wird auf elektronischem Wege aus dem Ausgangssignal der Photodiodenzeile bestimmt und liefert ein Mass für die Dicke des Gebäckstücks. Mit dieser Anordnung und der dabei verwendeten Beleuchtung können die anderen Abmessungen der Gebäckstücke jedoch nicht bestimmt werden. Die genaue Einhaltung des Abstandes zwischen der Photodiodenzeile und der Fläche, auf der die Gebäckstücke liegen, wird nicht überprüft, so dass die Genauigkeit dieser Anordnung beschränkt ist.

Da bei der Verarbeitung digitalisierter Bilder viele Bildpunkte gespeichert, ausgelesen, verarbeitet und wieder gespeichert werden müssen, ist bei derzeitigen Systemen zur visuellen Inspektion die Prüfgeschwindigkeit für Produktionszwecke zu gering.

Die vorliegende Erfindung stellt sich daher die Aufgabe, eine Vorrichtung zur automatischen Beschaffenheitsprüfung der eingangs genannten Art einzugeben, mit der neben den zweidimensionalen Abmessungen auch die dritte Dimension (Höhe) in einem zu prüfenden Muster überwacht werden kann und die bei relativ einfachem Aufbau eine schnelle Prüfung erlaubt.

Diese Aufgabe wird durch die im Hauptanspruch gekennzeichnete Erfindung gelöst; Ausgestaltungen

der Erfindung sind in den Unteransprüchen gekennzeichnet.

Die vorgeschlagene Prüfvorrichtung verwendet einen optischen Abtastkopf mit einer Lichtschnitteinrichtung zum zeilenweisen Abtasten des Prüflings, beispielsweise einer Leiterplatte. In dem Abtastkopf sind zwei Anordnungen von Diodenzeilen in einem geringen Abstand voneinander angeordnet, von denen die erste das Licht empfängt, das bei streifenförmiger, sträg einfallender Beleuchtung von der Oberfläche der isolierenden Grundplatte reflektiert wird und die zweite das Licht, das an der Oberfläche eines Leiterzugs reflektiert wird, sofern er sich in der gewünschten Nominalhöhe befindet. Die Ausgangssignale der Diodenzeilen werden entsprechend einem sich adaptiv änderndem Schwellwert in Binärwerte umgesetzt und Auswerteschaltungen zugeführt, die prüfen, ob die Nominalabmessungen in dem zweidimensionalen Bild eingehalten sind. Zur Erhöhung der Verarbeitungsgeschwindigkeit wird die Prüfung auf erlaubte Bildmerkmale parallel von mehreren jeweils einem Bildmerkmal zugeordneten Auswerteschaltungen durchgeführt. Erkannte Fehler werden markiert und können beispielsweise auf einem Fernsehschirm angezeigt werden.

Die vorgeschlagene Prüfvorrichtung ermöglicht, alle relevanten Konstruktionsparameter eines im wesentlichen zweidimensionalen Bildes mit einer reliefartigen Höhenstruktur zu ermitteln; da immer nur die gerade abgetastete Diodenzeile zu verarbeiten ist, wird die Verarbeitungsgeschwindigkeit des gesamten Systems so hoch, dass die Auswertung in gleicher Zeit wie die Abtastung erfolgt. Der Schaltungsaufwand ist gering, da keine aufwendigen Bezugsdaten (Mustervorlage) gespeichert und mit den aktuellen Daten verglichen werden müssen. Die optische Auflösung, die mit den heute verfügbaren Dioden erreichbar ist, liegt im Bereich von einigen µ.

Ausführungsbeispiele der Erfindung werden nun anhand von Zeichnungen näher erläutert.

Es zeigen:

Fig. 1 eine perspektivische Prinzipzeichnung des optischen Abtastkopfes mit Lichtschnitteinrichtung nach der Erfindung.

Fig. 2 ein Blockschaltbild eines opto-elektronischen Inspektionssystems mit einem Abtastkopf nach Fig. 1.

Fig. 3 einen Detailausschnitt aus einer Leiterplatte.

Fig. 4A, B eine Seitenansicht und eine perspektivische Ansicht einer weiteren Ausführungsform der Erfindung mit breitem Lichtband.

Fig. 5 eine Vorderansicht des Abtastkopfes zur Veranschaulichung seiner mechanischen Aufhängung.

Fig. 6 ein Blockschaltbild einer Ausführungsform der Erfindung, bei der metallisierte Bereiche zwischen den Leiterzügen erkannt werden können.

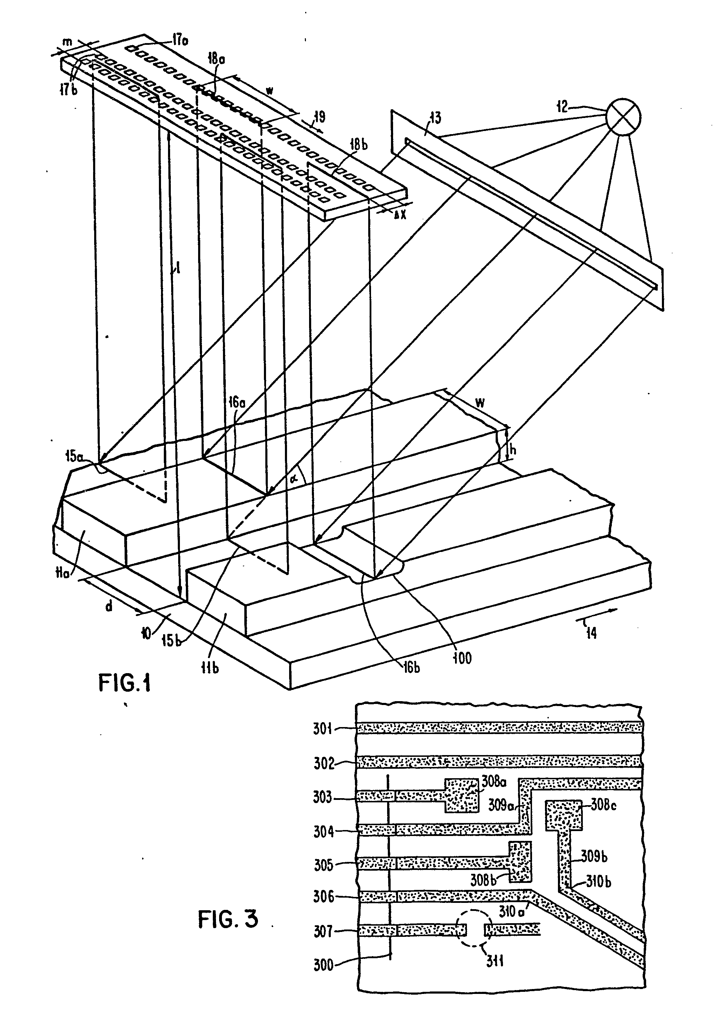

Fig. 1 zeigt in perspektivischer Darstellung einen Ausschnitt aus einer Leiterplatte, die aus einer isolierenden Gundplatte 10 und mehreren darauf angeordneten Leiterzügen 11a und 11b, beispielsweise aus Kupfer, besteht. Die Breite w, die Höhe h und der gegenseitige Abstand d dieser Leiterzüge 11a, 11b sollen nun über die gesamte Leiterplatte daraufhin untersucht werden, ob sie innerhalb der zugelassenen Wertebereiche liegen. Dazu wird die Platte mit einem Lichtband beleuchtet, das von einer Lampe 12 und einer davor angeordneten Schlitzblende 13 erzeugt wird und bezüglich der Leiterplatte einen Einfallswinkel $\alpha$ bildet. Der Einfallswinkel $\alpha$ liegt vorzugsweise in der Nähe von $\alpha \sim 45°$, das Lichtband ist senkrecht zur Längsachse der Leiterzüge 11 orientiert. Mit diesem Lichtband wird die gesamte Oberfläche der Leiterplatte mäanderförmig abgetastet, beispielsweise indem die gesamte Leiterplatte in einer Richtung senkrecht zum Lichtband (Pfeil 14) kontinuierlich oder schrittweise verschoben wird. Die Länge des erzeugten Lichtbandes liegt im Bereich von einigen cm, seine Breite bei etlichen µm und darüber. Ein optisches Abbildungssystem zwischen Lichtspalt 13 und Prüfling 10 erzeugt ein scharf begrenztes Bild des Spalts. Statt eines Lichtspalts kann auch eine Anordnung aus Lichtwellenleitern (optischen Fasern) zur Erzeugung einer spaltförmigen Lichtquelle verwendet werden.

Der Teil des Lichtbandes, der auf der Oberfläche der Grundplatte 10 auftrifft, ist in Fig. 1 mit den Geradenstücken 15a, 15b gekennzeichnet. Beim Auftreffen auf die Oberflächen der Leiterzüge 11a, 11b erzeugt das unter dem Winkel $\alpha$ auftreffende Lichtband die Geradenstücke 16a bzw. 16b, die bei senkrechter Aufsicht auf die Leiterplatte um die waagerechte Strecke $\triangle x$ verschoben sind, wobei diese Verschiebung von der jeweiligen Höhe h des Leiterzugs in folgender Weise abhängt:

Die aus der Lampe 12 und der Schlitzblende 13 bestehende Beleuchtungseinrichtung ist mechanisch starr mit zwei Anordnungen von Diodenzeilen 17a, 17b verbunden, wobei die gegenseitige Anordnung so gewählt ist, dass bei einem festgelegten Arbeitsabstand 1 der Diodenzeilen von der Grundplatte 10 die Diodenzeile 17a das Licht empfängt, das an der Oberfläche von Leiterzügen reflektiert wird, die gerade die erforderliche Nominalhöhe aufweisen. In dieser Stellung liegt der Schnittpunkt der Mittellinie des Lichtbandes und der durch die Diodenzeile verlaufenden Senkrechten zur Leiterzugfläche in der Nominalhöhe der Leiterzüge. Die Diodenanordnung 17b besteht aus einem Paar von Diodenzeilen, die parallel zur Diodenzeile 17a angeordnet sind und einen gegenseitigen Abstand m aufweisen. Die Symmetrielinie der Doppelzeile 17b ist von der Diodenzeile 17a in einem solchen Abstand angeordnet, dass beim Arbeitsabstand 1 das an der Grundplatte 10 reflektierte Licht gerade auf die Symmetrielinie der Doppelzeile 17b fällt. Bei einer Änderung des Arbeitsabstandes 1 wandert das an der Grundplatte 10 reflektierte Licht aus der Symmetrielinie aus und beaufschlagt die eine oder die andere der Diodenzeilen 17b, je nachdem, ob der Arbeitsabstand 1 grösser oder kleiner wird. Die Ausgangssignale der Doppeldiodenzeilen 17b werden dann als Stellsignale für die Wiederherstellung des nominalen Arbeitsabstandes 1 verwendet, der eine notwendige Voraussetzung für die im folgenden beschriebene Prüfung auf die Einhaltung der Nominalhöhe h der Leiterzüge ist. Zur Vermeidung von Fehlsteuerungen wird ein Stellsignal nur erzeugt, wenn eine Mindestanzahl von Dioden in der Doppelzeile 17b belichtet ist.

Zwischen den Diodenzeilen 17 und dem Prüfling ist eine optische Abbildungseinrichtung vorgesehen. Zur Einstellung der Komponenten des Abtastkopfes gegen die zu untersuchenden Muster des Prüflings können Justiermittel vorgesehen werden.

Wie erwähnt, ist bei einem vorgegebenen Arbeitsabstand 1 die geometrische Konfiguration von Lichtquelle und Diodenzeilen so gewählt, dass bei der Reflexion des Lichtbandes an einem Leiterzug 11a mit Nominalhöhe h ein Abbild 18a auf der Diodenzeile 17a erzeugt. Trifft das Lichtband, beispielsweise im Teil 16b auf einen Leiterzug, dessen Höhe nicht der Nominalhöhe h entspricht, wie es beispielsweise in der Vertiefung 100 des Leiterzugs 11b dargestellt ist, so gelangt das reflektierte Lichtband 18b nicht auf die Diodenzeile 17a, sondern wird je nach Richtung der Höhenabweichung links oder rechts davon abgelenkt. Der Betrag $\triangle x$ dieser Ablenkung hängt davon ab, wie weit die tatsächliche Höhe des Leiterzugs von der Nominalhöhe abweicht. Die Verschiebung $\triangle x$ braucht nicht genau ermittelt zu werden, wenn sich die Prüfung der Leiterzughöhe auf die Überwachung des Nominalhöhenbereichs beschränkt. Der Toleranzbereich innerhalb dessen die Nominalhöhe liegen muss, kann dadurch eingestellt werden, dass die lichtempfindliche Fläche der Dioden und/oder die Breite des Lichtbandes entsprechend gewählt werden. Typische Werte für den überprüften Höhenbereich liegen bei einigen 10 μm mit einer Toleranzbreite von einigen μ.

Beim schrittweisen Abtasten der Leiterplatte wird das von der Belichtung hervorgerufene Ladungsbild der Diodenzeile 17a ausgewertet; dazu werden die Diodenzeilen sequentiell ausgelesen (in Pfeilrichtung 19), die Ausgangssignale in eine Binärstellung umgesetzt und an Auswerteschaltkreise gegeben, die feststellen, ob die Breite der von der Diodenzeile 17a empfangenen Hell-Dunkel-Muster der Nominalbreite der Leiterzüge und den Nominalabständen entspricht.

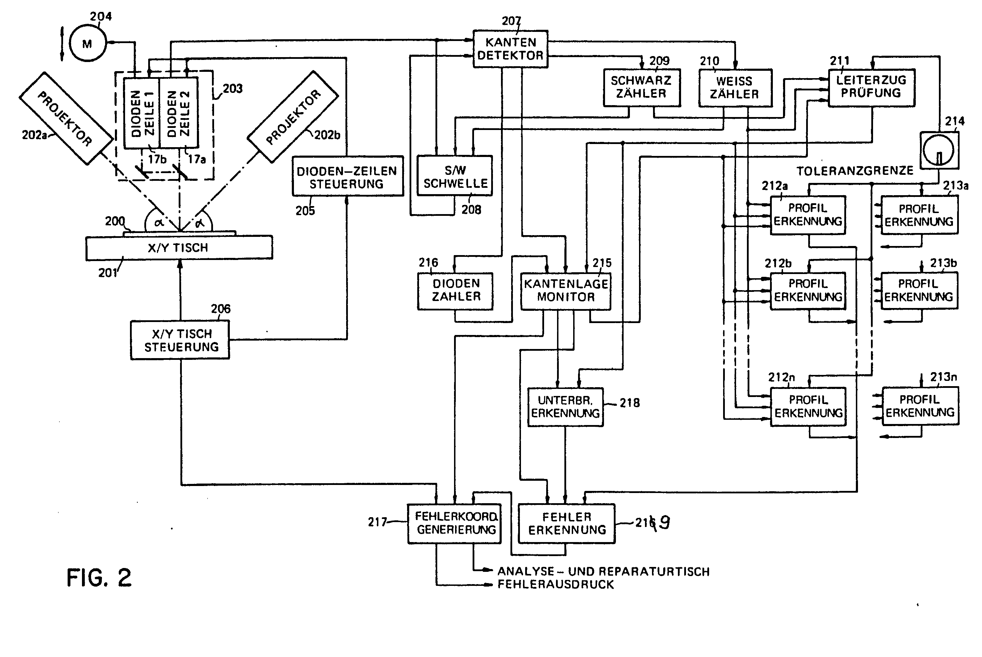

Einzelheiten der Auswerteschaltung für die aus den Diodenzeilen 17a ausgelesenen Signale werden nun anhand von Fig. 2 erläutert, die als Blockschaltbild die einzelnen Komponenten eines vollständigen Systems zur automatischen Beschaffenheitsprüfung von Leiterplatten zeigt. Die zu prüfende Leiterplatte 200 liegt auf einem Kreuzsupport (X-Y-Tisch) 201 und wird von zwei symmetrisch zu ihrer Normalen angebrachten Projektoren 202a, 202b mit je einem Lichtband beleuchtet, das unter einem Winkel α auf die Leiterplatte auftrifft. Die Verdoppelung der Lichtbandprojektoren verhindert die Entstehung von unerwünschten Schattengebieten, beispielsweise bei rauhen Oberflächen. Das an der Leiterplatte 200 reflektierte Licht wird von einem senkrecht über der Leiterplatte angebrachten Abtastkopf 203 registriert, in dem die anhand von Fig. 1 erläuterten Diodenzeilen 17a und 17b enthalten sind. Die Ausgangssignale der Diodendoppelzeile 17b wird als Stellsignal einem Motor 204 zugeführt, der den Arbeitsabstand zwischen Abtastkopf 203 und der Leiterplatte 200 konstant hält. Der Kreuzsupport 201 wird von einer Tischsteuerung 206 vorzugsweise kontinuierlich verschoben; nach jeder Verschiebung um 12 μ gibt die mit der Tischsteuerung verbundene Diodenzeilensteuerung 205 ein Auslesesignal an die Diodenzeilen 17a, 17b. Die gesamte Leiterplatte 200 wird vorzugsweise mäanderförmig unter den Lichtbändern der Projektoren 202a, 202b hinweggeführt.

Die Ladungsverteilung in der Diodenzeile 17a stellt die örtliche Helligkeits-Verteilung des an der Leiterplatte 200 reflektierten Lichtbandes dar, und wird zur Auswertung seriell einem Kantendetektor 207 zugeführt, der die Analogwerte der Diodensignale entsprechend einem laufend nachgeführten Schwellwert in eine Binärdarstellung umsetzt. Die Einstellung des jeweiligen Schwarz- Weiss- Schwellwerts erfolgt in der Schaltung 208 in der Weise, dass beim Auftreten einer Kante die Signale einer festgelegten Anzahl von Dioden links und rechts der Kante summiert und daraus ein Mittelwert gebildet wird. Dieser Mittelwert wird als aktueller Schwellwert für die Binärumsetzung der folgenden Diodensignale ausgewählt, so dass Änderungen der Beleuchtung oder der lokalen Reflexionseigenschaften der Leiterplatte 200 zu keiner Verschiebung der Kantenlage im Diodenbild Anlass geben.

Das binäre Ausgangssignal des Kantendetektors 207 wird zwei Zählern 209, 210 zugeführt, mit denen die aufeinanderfolgenden Hell/Dunkel (Weiss/Schwarz)-Elemente im Binärbild gezählt werden, das aus den Ausgangssignalen der abgetasteten Diodenzeile 17a erzeugt wurde. Die Ausgangssignale der Zähler 209, 210 werden einerseits dem Schaltkreis 208 für die Einstellung der Schwarz/Weiss-Schwelle zugeführt, um jeweils die festgelegte Anzahl von Bildelementen links und rechts einer Kante ermitteln zu können; ausserdem sind die Zähler 209, 210 mit einer Schaltung 211 verbunden, die feststellt, ob die Nominalwerte für die Leiterzugbreite und für die gegenseitigen Abstände der Leiterzüge eingehalten sind. Die Prüfung erfolgt in einfacher Weise dadurch, dass die Länge der zusammenhängenden Hell- bzw. Dunkel-Bereiche des Binärsignals mit vorgegebenen Werten verglichen wird. Die Vorgabewerte können für die verschiedenen Arten von zu untersuchenden Leiterplatten in einer Diskettenstation 214 gespeichert und bei Beginn der Prüfung in den Schaltkreis 211 übertragen werden.

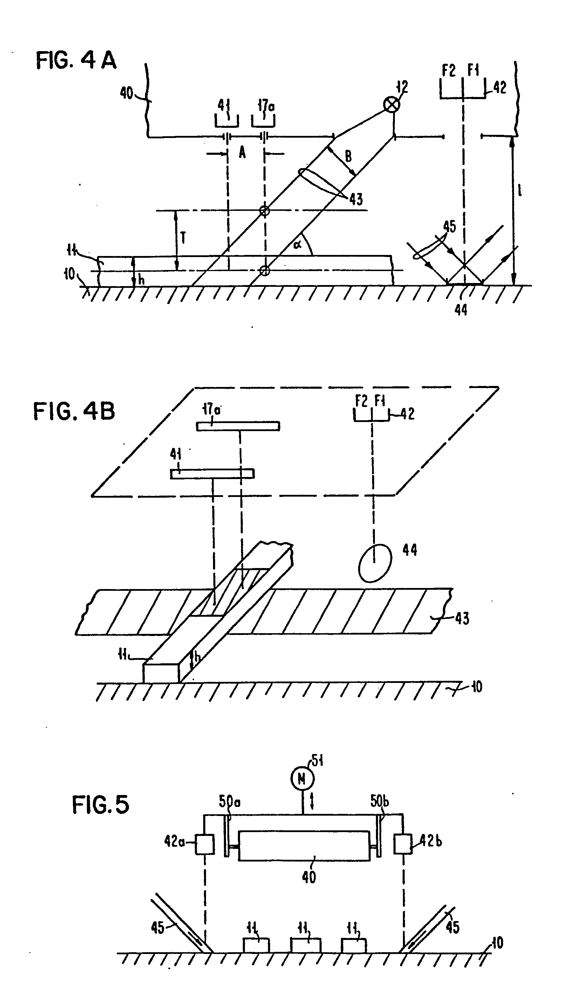

Dem Prüfschaltkreis 211 werden weiterhin die Ausgangssignale eines Kantenlagemonitors 215 zugeführt, mit dessen Hilfe die verschiedenen von einem Lichtband gleichzeitig beaufschlagten Leiterzüge unterschieden werden können. In dem Beispiel von Fig. 3 werden in einer Abtaststellung die Leiterzüge 303 - 307 gleichzeitig untersucht (die Linie 300 entspricht dem Bild des reflektierten Lichtbandes); der Kantenlagemonitor enthält dementsprechend Information über die Kantenlage eines jeden Leiterzugs, um im nachfolgenden Abtastschritt die dann ermittelten Kanten den jeweiligen Leiterzügen richtig zuordnen zu können. Als Eingangssignale empfängt der Monitor 215 die Ausgangssignale des Kantendetektors 207 und der Prüfschaltung 211 sowie den Stand eines Diodenzählers 216, der wiederum vom Kantendetektor 207 beaufschlagt wird. Der Diodenzähler liefert die Adresse der jeweiligen Kante, die im Monitor 215 bis zur nächsten Abtastung gespeichert wird.

Stellt der Prüfschaltkreis 211 für Leiterzugbreite und Leiterzugabstand Werte fest, die ausserhalb des erlaubten Bereichs liegen, so braucht dies nicht unbedingt auf einen Fehler im Leiterbild hinzuweisen. Neben den Leiterzügen weist die Leiterplatte eine Reihe von weiteren erlaubten geometrischen Figuren von Leiterteilen auf, beispielsweise Lötaugen (in Fig. 3 mit 308 bezeichnet) oder rechtwinklig bzw. schräg abknickende Leiterzüge 309, 310. Zur Erhöhung der Verarbeitungsgeschwindigkeit ist nun für jedes der in Frage kommenden Profile eine Profilerkennungsschaltung 212a - 212n vorgesehen. Ein Satz dieser Profilerkennungsschaltkreise ist ausserdem für jeden bei einem Abtastvorgang verfolgten Leiterzug (z.B. 303 - 307 in Fig. 3) vorgesehen. Stellt die Prüfschaltung 211 einen ausserhalb des zugelassenen Bereichs liegenden Wert fest, so aktiviert sie die für den betreffenden Leiterzug zuständige Gruppe von Profilerkennungsschaltungen, z.B. 212a - 212n, die dann bei jedem weiteren Abtastschritt feststellen, ob die von der Prüfschaltung 211 beanstandeten Werte mit einem der zugelassenen Profile übereinstimmen. Wird beispielsweise ein Lötauge 308 abgetastet, so wird der dafür zuständige Profilerkennungskreis ein «Gefunden» Signal abgeben, wenn das Lichtband über das gesamte Lötauge hinweggelaufen ist. Bei nicht erlaubten Profilen gibt keiner der Profilerkennungsschaltkreise 212 ein «Gefunden» Signal ab, so dass die Fehlererkennungsschaltung 219, die mit den Ausgängen der Profilerkennungsschaltung 212, 213 ... verbunden ist, einen Fehler erkennt. Die Profilerkennungsschaltkreise 212, 213 können mit Hilfe von Vorgabedaten aus der Diskettenstation 214 auf die jeweiligen bei einer Leiterplatte zugelassenen Profile eingestellt werden.

Eine Leitungsunterbrechung, z.B. im Gebiet 311 der Leiterbahn 307 von Fig. 3 wird in einer Unterbrechungserkennungsschaltung 218 erkannt, die Eingangssignale von der Prüfschaltung 211 und den Kantenlagemonitor 215 empfängt. Die Prüfschaltung 211 kann derartige Fehler nicht allein erkennen, da die Diodenzeile 17a an dieser Stelle nur einen (an sich erlaubten) grösseren Abstand zwischen mehreren Leiterbahnen anzeigt. In der Unterbrechungserkennungsschaltung 218 wird von der Forderung Gebrauch gemacht, dass Leiterzüge nicht stumpf enden dürfen, sondern immer mit einem Lötauge oder einer entsprechenden anderen geometrischen Figur abgeschlossen sein müssen.

Der Fehlererkennungsschaltung 219 werden alle Signale zugeführt, die auf Unregelmässigkeiten hindeuten (unzulässiges Profil, falsche Kantenlage, unterbrochener Leiterzug). Der Ort jedes aufgetretenen Fehlers wird anhand der Tischkoordinaten, die von der Tischsteuerung 206 geliefert werden, ermittelt und dienen zur Erstellung eines Fehlerprotokolls und/oder zur Einstellung eines Analyse- und Reparaturtisches, auf den die fehlerhafte Leiterplatte 200 gelegt wird, so dass die fehlerhafte Stelle automatisch angefahren wird.

Wenn in einem Prüfling mehrere Höhenstufen überwacht werden sollen, wird für jede Höhe eine entsprechend eingestellte Abtastdiodenzeile 17a vorgesehen.

In Abwandlung der bisher beschriebenen Ausführungsbeispiele mit sehr engem Lichtband (Breite in der Grössenordnung von 10 μ) können auch breitere Lichtbänder bis 100 μ und darüber verwendet werden, wenn die erlaubten Leiterzughöhen einen relativ breiten Toleranzbereich ausfüllen. In der als Seitenansicht ausgeführten Fig. 4A wird dementsprechend ein auf der Grundplatte 10 liegender Leiterzug 11 mit einem Lichtband 43 der Breite B beleuchtet, das über entsprechende optische Abbildungsmittel und Blenden von der Lichtquelle 12 erzeugt wird. Wie vorher trifft dieses Lichtband unter einem Winkel α auf den Leiterzug auf. Die Nominalhöhe h des Leiters 11 kann in einem Bereich T schwanken. Die Diodenzeile 17a ist dann senkrecht über den Schnittpunkten der Lichtbandbegrenzung mit den Grenzen des erlaubten Wertebereichs T angeordnet. Wenn die Diodenzeile 17a also kein Licht empfängt, liegt die Leiterzughöhe h ausserhalb des erlaubten Wertebereichs.

Bei derartig breiten Lichtbändern ist die in den früheren Ausführungsbeispielen beschriebene Art der Höhenregelung des Substrats nicht mehr möglich. Statt dessen wird eine optische Brückenanordnung verwendet, bei der ein im Abtastkopf 40 angeordneter Photodetektor 42 zwei nebeneinanderliegende und aufeinander abgestimmte photoempfindliche Flächen F1 und F2 aufweist. Dieser Photodetektor empfängt Licht aus einem ellipsenförmigen Gebiet 44, das von einem schräg auf die Grundplatte 10 auftreffenden runden Laserstrahlbündel 45 beleuchtet wird. Wenn die Grundplatte 10 ihren Nominalabstand 1 vom Abtastkopf der vorliegenden Erfindung einhält, sehen beide photoempfindlichen Flächen F1 und F2 denselben Anteil des ellipsenförmigen Auftreffgebiets, so dass eine angeschlossene elektrische Brückenschaltung kein Ausgangssignal liefert. Bei einer Veränderung des Abstandes 1 verschiebt sich auch die Lage des ellipsenförmig beleuchteten Gebiets, so dass die Photoflächen F1 und F2 ungleichmässig beleuchtet werden und ein Ausgangssignal abgeben, das zur Höhenregelung verwendet werden kann. Dieses Ausgangssignal ist eine kontinuierlich sich ändernde Analoggrösse und erlaubt eine sehr schnelle Höhenregelung auch bei kleinsten Unebenheiten (<< 10 μm) der Grundplatte. Ein weiterer Vorteil dieser Anordnung besteht darin, dass sie unempfindlich gegen Änderungen der lokalen Reflexionseigenschaften der Leiterplatte ist. Bei einer echten Höhenänderung der Grundplatte ändern sich beide Ausgangssignale der photoempfindlichen Flächen F1, F2, und zwar gegenläufig. Wird dagegen während des Abtastvorgangs eine stark reflektierende Leiterfläche überstrichen, so ändert sich zuerst das eine und dann das andere Ausgangssignal, wobei das jeweils andere Signal konstant bleibt. Diese Eigenschaft der Einrichtung zur Höhenregelung kann in einer nachgeschalteten logischen Schaltung ausgewertet werden.

Im Abtastkopf 40 des Ausführungsbeispiels nach Fig. 4A ist ausserdem eine weitere Diodenzeile 41 vorgesehen, die im Abstand A parallel zur Diodenzeile 17a liegt. Die Aufgabe dieser Diodenzeile ist es, festzustellen, ob auf der Grundplatte 10 ausser den erlaubten Leiterzügen weitere metallisierte Gebiete vorhanden sind, die ausserhalb des erlaubten Höhenbereichs von Leiterzügen liegen und somit von der Diodenzeile 17a nicht «gesehen» werden können.

Bei derartigen metallischen Flächen kann es sich beispielsweise um dünne Kupferreste zwischen den eigentlichen Leiterzügen handeln, die nicht vollständig weggeätzt wurden und zu Kurzschlüssen führen können. Bei den in Fig. 4A angedeuteten Verhältnissen erstreckt sich das Gesichtsfeld der Diodenzeile 41 von der Grundplatte (d.h. Höhe 0) bis zu einem Wert über der dort eingezeichneten Leiterhöhe h. Andere Gesichtsfelder dieser Diodenzeile sind durch entsprechende Wahl des Abstandes A und/oder der Breite B des Lichtbandes einstellbar.

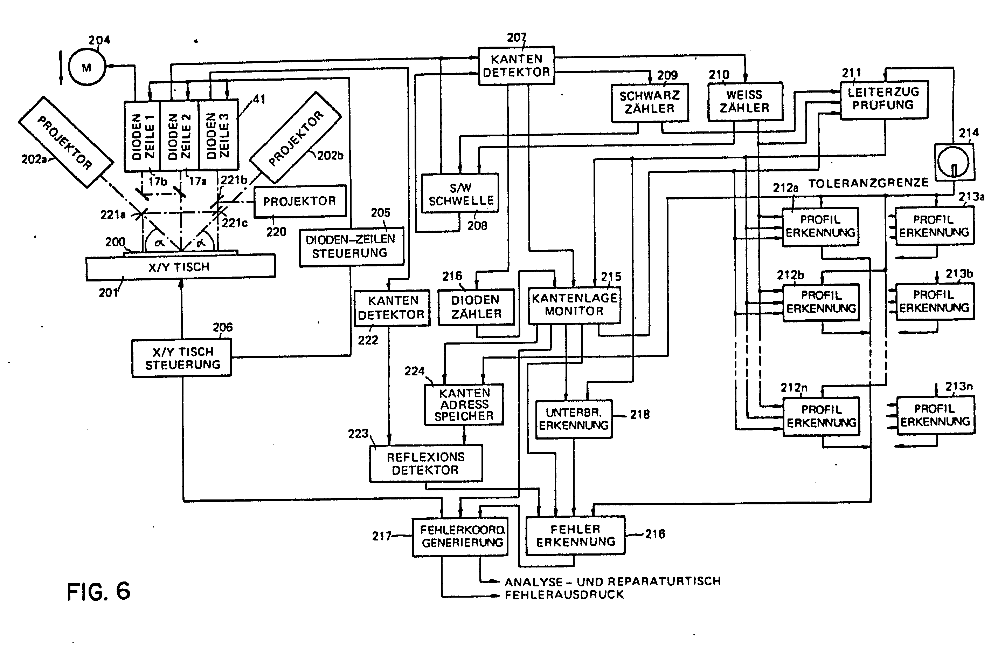

Da die Diodenzeile 41 also auch einen Teil der ordnungsgemässen Leiterzüge erkennt, ist es notwendig, diese auch von der Diodenzeile 17a erkannten Leiterzüge auf elektronischem Wege zu berücksichtigen (d.h. vom Gesichtsfeld der Diodenzeile 41 abzuziehen), damit das Ausgangssignal der Diodenzeile 41 nur dann zu einem Fehlersignal führt, wenn ein metallisiertes Gebiet ausserhalb der Leiterzugsbereiche verarbeitet wird. Die zu dieser elektronischen Verarbeitung erforderliche Schaltung wird später anhand der Fig. 6 näher erläutert.

Fig. 4B zeigt in stark schematisierter Weise eine Perspektivansicht des eben besprochenen Lichtschnittverfahrens mit breiten Lichtbändern, die in Fig. 4B schraffiert dargestellt sind. Die Bezugszeichen in Fig. 4B entsprechen denen von Fig. 4A.

Fig. 5 zeigt eine schematische Vorderansicht eines optischen Inspektionssystems der anhand von Fig. 4A geschilderten Art, bei der sich der Abtastkopf 40 senkrecht zur Zeichenebene bewegt. Die Aufhängung des Kopfes 40 erfolgt über piezoelektrische Elemente 50a, 50b, die über Stellsignale der Photodioden 42a, 42b betätigt werden und somit eine schnelle Höhennachführung bei sich ändernder Höhe der Grundplatte 10 erlauben. Bei dieser Anordnung sind auch Korrekturen bei einer Schieflage der Grundplatte 10 möglich. Grössere Höhendifferenzen, die beim Überfahren der Grundplatte 10 festgestellt werden, können mit dem Motor M ausgeglichen werden, der die gesamte Anordnung mit Kopf 40, piezoelektrischen Elementen 50 und Photodetektoren 42 hebt oder senkt. Die Sensoren 42a, 42b sind dabei so angeordnet, dass sie in Bewegungsrichtung gesehen etwas vor dem Auftreffgebiet des Lichtbandes liegen, so dass bei gebogenen Grundplatten ausreichend Zeit bleibt, die Nominalhöhe zu korrigieren, bis der Abtastkopf über der beleuchteten Stelle der Grundplatte ankommt. Die Ausgangssignale der optischen Sensoren werden in einem (nicht dargestellten) logischen Schaltkreis aufbereitet, bevor sie als Stellsignale für die piezoelektrischen Elemente 50 verwendet werden.

Fig. 6 zeigt eine schematische Gesamtdarstellung einer Einrichtung zur optischen Beschaffenheitsprüfung, bei der eine zusätzliche Diodenzeile 41 vorgesehen ist, mit der zwischen den Leiterzügen vorhandene Metallisierungen festgestellt werden. Diese anhand von Fig. 4A erläuterte zusätzliche Diodenzeile kann auch in einem Abtastkopf Verwendung finden, der schmale Lichtbänder verarbeitet, wie sie anhand der Fig. 1 erläutert wurden. In diesem Fall wird ein zusätzlicher Projektor 220 verwendet (an dessen Stelle könnte auch ein Teil des Lichtes der Projektoren 202a oder 202b ausgekoppelt werden), der jeweils in Bewegungsrichtung gesehen hinter der eigentlichen Messdiodenzeile 17a ein weiteres schmales Lichtband erzeugt, das senkrecht auf die Leiterplatte auftrifft. Dies ist in Fig. 6 mit Hilfe der Umlenkspiegel 221a bis c erfolgt; der Spiegel 221c ist dabei verschieblich angeordnet, um die beiden oben besprochenen Möglichkeiten der Strahlführung einzustellen. Das Ausgangssignal der zusätzlichen Diodenzeile 41 wird in einem Kantendetektor 222 ausgewertet, der in seiner Funktion dem früher erläuterten Kantendetektor 207 entspricht. Die Prüfung auf metallisierte Gebiete zwischen den eigentlichen Leiterzügen erfolgt in einem logischen Schaltkreis 223, dem einerseits die im Schaltkreis 222 erkannten metallisierten Gebiete zugeführt werden, die in einem Speicher 224 verzögert wurden, um die zeitliche Nacheilung der Ausgangssignale der Diodenzeile 41 auszugleichen, die in Bewegungsrichtung gesehen hinter der Diodenzeile 17a angeordnet ist. Im logischen Schaltkreis 223 erfolgt dann eine Subtraktion der als Leiterzug erkannten metallisierten Gebiete von den durch Diodenzeile 41 festgestellten metallisierten Gebieten. Bei einer Differenz ungleich 0 (oder oberhalb eines vorgegebenen Schwellwerts) liegt eine unerwünschte Metallisierung zwischen den Leiterzügen vor, und Schaltkreis 223 gibt ein Fehlersignal an die Fehlererkennungsschaltung 219 ab.

## Patentansprüche

1. Vorrichtung zur automatischen optischen, dreidimensionalen Beschaffenheitsprüfung von im wesentlichen zweidimensionalen Prüfmustern mit Reliefstruktur, insbesondere gedruckten Leiterplatten oder photolothographischen Masken, gekennzeichnet durch die folgenden Merkmale:
— ein optischer Abtastkopf (40) ist über dem relativ dazu beweglichen Prüfmuster (10) in einem Arbeitsabstand (1) angeordnet, der durch Regeleinrichtungen (17b; 22) auf einem vorbestimmten Wert gehalten wird,
— der Abtastkopf enthält eine Beleuchtungsanordnung, die ein senkrecht zur Bewegungsrichtung verlaufendes Lichtband (43) unter einem Winkel (α) schräg auf das Prüfmuster richtet,
— der Abtastkopf enthält mindestens eine Photodiodenzeile (Abtastdiodenzeile 17a), die parallel zum Lichtband und senkrecht über der Schnittlinie des Lichtbandes mit der Ebene angebracht ist, die der zu prüfenden Nominalhöhe (a) entspricht,
— es sind Steuervorrichtungen (205) vorgesehen, mit denen die Photodiodenzeile periodisch ausgelesen und einem Kantendetektor (207) zugeführt wird, der mit einem Hell-Dunkel-Schwellwert eine Binärdarstellung erzeugt, die kantengetriggerten Zählern (209, 210) zugeführt wird, um die Länge zusammenhängender Hell- bzw. Dunkelbereiche festzustellen und die Zählwerte mit vorgegebenen Nominalwerten zu vergleichen (im Prüfschaltkreis 211) und
— es sind Prüfschaltungen für erlaubte Muster (Profilerkennungsschaltkreise 212) vorgesehen, die bei Überschreitung der Nominalwerte während der Auswertung angestossen werden.

2. Vorrichtung nach Anspruch 1, dadurch gekennzeichnet, dass das Lichtband eine Breite in der Grössenordnung von 10 μm aufweist.

3. Vorrichtung nach Anspruch 2, dadurch gekennzeichnet, dass der Abtastkopf parallel zur Abtastdiodenzeile (17a) ein Paar weiterer Diodenzeilen (17b) mit einem gegenseitigen Abstand (m) aufweist, in dem das am Prüfmuster (10) reflektierte Licht auftrifft, wenn der Arbeitsabstand (1) eingehalten ist und dass die Ausgangssignale des Diodenzeilenpaares (17b) als Stellsignale für die Wiederherstellung des Arbeitsabstandes (1) dienen.

4. Vorrichtung nach Anspruch 1, dadurch gekennzeichnet, dass das Lichtband eine Breite in der Grössenordnung von 100 μm aufweist und dass die Schnittpunkte seiner Begrenzungslinien mit den Grenzen des erlaubten Höhenbereichs (T) senkrecht unter der Abtastdiodenzeile (17a) liegen.

5. Vorrichtung nach Anspruch 4, dadurch gekennzeichnet, dass der Abtastkopf (40) zur Regelung des Arbeitsabstandes (1) einen Photodetektor (42) mit zwei aufeinander angepassten photoempfindlichen Flächen (F1, F2) enthält, die senkrecht über einer auf der Grundplatte (10) ellipsenförmig beleuchteten Fläche (44) angeordnet sind.

6. Vorrichtung nach einem der Ansprüche 1 bis 5, dadurch gekennzeichnet, dass das Prüfmuster mit zwei symmetrisch zu seiner Flächennormalen unter gleichem Winkel (α) auftreffenden Lichtbändern beleuchtet wird (durch Projektoren 202a, 202b).

7. Vorrichtung nach einem der Ansprüche 1 bis 6, dadurch gekennzeichnet, dass Vorrichtungen (208) vorgesehen sind, die mit dem Ausgang der Abtastdiodenzeile, den kantengetriggerten Zählern (209, 210) und dem Kantendetektor (207) verbunden sind, um den Hell-Dunkelschwellwert des Kantendetektors entsprechend den gemessenen Helligkeitswerten nachzuführen.

8. Vorrichtung nach einem der Ansprüche 1 bis 7, dadurch gekennzeichnet, dass der Abtastkopf (40) eine weitere, zur ersten Diodenzeile (17a) parallel angeordnete Diodenzeile (41) enthält, die senkrecht über den Schnittpunkten der Begrenzungslinien des Lichtbandes (43) mit einem weiteren erlaubten Höhenbereich liegt und dass die Ausgangssignale der weiteren Diodenzeile einem weiteren Kantendetektor (222) zugeführt werden, dessen Ausgangssignale in einem Detektor (223) zusammen mit den Signalen verarbeitet werden, die von dem ersten Kantendetektor (207) erzeugt werden.

## Claims

1. Apparatus for the automatic optical, three-dimensional property testing of substantially two-dimensional relief-structured test patterns, in particular circuit cards or photolithographic masks, characterized by the following features:
— an optical scanning head (40) positioned above the test pattern (10) movable relative thereto at an operating distance (1) kept at a predetermined value by control means (17b; 22),
— said scanning head comprising an illuminating means directing a light band (43), obliquely incident at an angle (α) and extending perpendicularly to the direction of movement, to the test pattern,
— said scanning head also comprising at least one linear photodiode array (linear scanning diode array 17a) positioned parallel to the light band and perpendicularly above the intersection of the light band with the plane corresponding to the nominal height (a) to be tested,
— control means (205) by which the linear photodiode array is periodically read and fed to an edge detector (207) generating by means of a black and white threshold value a binary representation which is fed to edge-triggered counters (209, 210) for determining the length of continuous light and dark areas and for comparing the counts with predetermined nominal values (in the test circuit 211), and
— test circuits for permissible patterns (profile recognition circuits (212) which are triggered if the nominal values are exceeded during evaluation.

2. Apparatus according to claim 1, characterized in that the light band has a width of the order of 10 μm.

3. Apparatus according to claim 2, characterized in that the scanning head comprises parallel to the linear scanning diode array (17a) a pair of further linear diode arrays (17b) with a mutual spacing (m) in which the light reflected at the test pattern (10) is incident if the operating distance (1) has been kept, and that the output signals of the linear diode array pair (17b) act as control signals for restoring the operating distance (1).

4. Apparatus according to claim 1, characterized in that the light band has a width of the order of 100 μm, and that the intersections of its boundary lines with the boundaries of the permissible height range (T) are positioned perpendicularly below the linear diode array (17a).

5. Apparatus according to claim 4, characterized in that the scanning head (40) for controlling the operating distance (1) comprises a photodetector (42) with two photosensitive surfaces (F1, F2) matched to each other and which are positioned perpendicularly above an elliptically illuminated surface (44) on the base plate (10).

6. Apparatus according to any one of the claims 1 to 5, characterized in that the test pattern is illuminated (through projectors 202a, 202b) by means of two light bands symmetrically incident relative to its surface normal at the same angle (α).

7. Apparatus according to any one of the claims 1 to 6, characterized in that means (208) are provided which are connected to the output of the linear scanning diode array, the edge-triggered counters (209, 210) and the edge detector (207) for up-dating the black and white threshold value of the edge detector according to the measured brightness values.

8. Apparatus according to any one of the claims 1 to 7, characterized in that the scanning head (40) comprises a further linear diode array (41) arranged parallel to the first linear diode array (17a) and positioned perpendicularly above the intersections of the boundary lines of the light band (43) with a further permissible height range, and that the output signals of the further linear diode array are fed to a further edge detector (222), whose output signals are processed in a detector (223) together with the signals generated by the first edge detector (207).

## Revendications

1. Dispositif de contrôle optique automatique tridimensionnel de configurations à contrôler pratiquement bidimensionnelles à structure en relief, notamment des cartes de circuits imprimés ou de masques photolithographiques, caractérisé par les caractéristiques suivantes:
— une tête d'exploration optique (40) est disposée au-dessus de la configuration à contrôler (10) mobile par rapport à elle, à une distance de travail (1) qui est maintenue à une valeur prédéterminée par des dispositifs de réglage (17b; 22);
— la tête d'exploration contient un agencemment d'éclairage qui dirige une bande lumineuse (43) perpendiculaire à la direction de déplacement obliquement sur la structure à contrôler, suivant un angle (α);
— la tête d'exploration contient au moins une rangée de photodiodes (rangées de diodes d'exploration 17a) placée parallèlement à la bande lumineuse et verticalement au-dessus de la ligne d'intersection de la bande lumineuse avec le plan correspondant à la hauteur nominale (a) à contrôler;
— il comporte des dispositifs de commmande (205) au moyen desquels la ligne de photodiodes est lue périodiquement et transmise à un détecteur de discontinuités (207) qui produit avec une valeur de seuil clair-foncé une représentation binaire transmise à des compteurs (209, 210) déclenchés par les discontinuités, pour déterminer la longueur de zones claires ou foncées contiguës et comparer les positions de comptage avec des valeurs nominales prédéterminées (dans le circuit de contrôle 211), et
— il comporte des montages de contrôle pour configurations permises (circuits de reconnaissance de profils 212) qui sont déclenchés lors du dépassement des valeurs nominales pendant le traitement.

2. Dispositif selon la revendication 1, caractérisé en ce que la bande lumineuse a une largeur de l'ordre de 10 micromètres.

3. Dispositif selon la revendication 2, caractérisé en ce que la tête d'exploration comporte parallèlement à la rangée de diodes d'exploration (17a) une paire d'autres rangées de diodes (17b) présentant une distance mutuelle (m), sur laquelle tombe la lumière réfléchie sur la configuration à contrôler (10), lorsque la distance de travail (1) est respectée, et en ce que les signaux de sortie de la paire de rangées de diodes (17b) constituent des signaux de réglage pour le rétablissement de la distance de travail (1).

4. Dispositif selon la revendication 1, caractérisé en ce que la bande lumineuse présente une largeur de l'ordre de 100 micromètres, et en ce que les points d'intersection de ses lignes de délimitation avec les limites de l'intervalle de cotes (T) autorisé sont placés verticalement au-dessous de la rangée de diodes d'exploration (17a).

5. Dispositif selon la revendication 4, caractérisé en ce que la tête d'exploration (40) contient, pour régler la distance de travail (1), un photodétecteur (42) comportant deux surfaces photosensibles (F1, F2) en correspondance mutuelle qui sont disposées verticalement au-dessus d'une surface (44) éclairée ellipsoïdalement sur la plaque de base (10).

6. Dispositif selon l'une quelconque des revendications 1 à 5, caractérisé en ce que la configuration à contrôler est éclairée avec deux bandes lumineuses à incidence de même angles (α) symétriques par rapport à la normale à sa surface (par des projecteurs 202a, 202b).

7. Dispositif selon l'une quelconque des revendications 1 à 6, caractérisé en ce qu'il comporte des dispositifs (208) reliés à la sortie de la rangée de diodes, aux compteurs (209, 210) déclenchés par des discontinuités et au détecteur de discontinuités (207), pour rétablir la valeur de seuil clair-foncé du détecteur de discontinuités, selon les luminosités mesurées.

8. Dispositif selon l'une quelconque des revendications 1 à 7, caractérisé en ce que la tête d'exploration (40) contient une autre rangée de diodes (41) disposée parallèlement à la première rangée de diodes (17a), qui est placée verticalement au-dessus des points d'intersection des lignes de délimitation de la bande lumineuse (43) avec un autre intervalle de cotes autorisé, et en ce que les signaux de sortie de cette autre rangée de diodes sont transmis à un autre détecteur de discontinuités (222) dont les signaux de sortie sont traités dans un détecteur (223), en même temps que les signaux qui sont engendrés par le premier détecteur de discontinuités (207.

**FIG.1**

**FIG. 3**

FIG. 2

FIG. 4 A

FIG. 4B

FIG. 5

FIG. 6